# FASCICULE DE BREVET EUROPEEN

(11) **EP 0 435 773 B1**
(45) Date de publication et mention de la délivrance du brevet: **22.02.1995**
(21) Numéro de dépôt: 90403784.3
(22) Date de dépôt: 27.12.1990
(51) Int. Cl.: H04N 3/15, H01L 27/14

(54) **Dispositif pour prises de vues à circuits de balayage intégrés**
Bildaufnahmeeinrichtung mit integrierten Ablenkschaltungen
Image pick-up device with integrated deflection circuits

(30) Priorité: 29.12.1989 FR 8917448
(43) Date de publication de la demande: 03.07.1991
(73) Titulaire: COMMISSARIAT A L'ENERGIE ATOMIQUE, 75015 Paris (FR)
(72) Inventeur: Audaire, Luc, F-38000 Grenoble (FR); Pantigny, Philippe, F-38000 Grenoble (FR)
(74) Mandataire: Poulin, Gérard

(56) Documents cités:
- EP-A- 0 145 543
- EP-A- 0 193 443
- DE-A- 3 043 677

## Description

La présente invention a pour objet un dispositif pour prises de vues à circuits de balayage intégrés. Elle s'applique notamment à la réalisation de dispositifs de grande précision et dont les dimensions sont réduites.

On connaît des dispositifs pour prises de vues à circuits de balayage intégrés ; ceux-ci utilisent des structures dites "à transfert de charges" (Dans la suite de la description, ces structures seront notées DTC pour dispositif à transfert de charges, ce qui correspond à la terminologie anglosaxonne CCD : "charge coupled device"). Pour faciliter la lecture du présent texte, on peut se reporter utilement au chapitre E2210 p 1-12 de la revue "Techniques de l'Ingénieur" qui fait une synthèse sur les dispositifs à transfert de charges et leur application à des dispositifs de prises de vues. Un tel dispositif est aussi décrit dans EP-A-0193443.

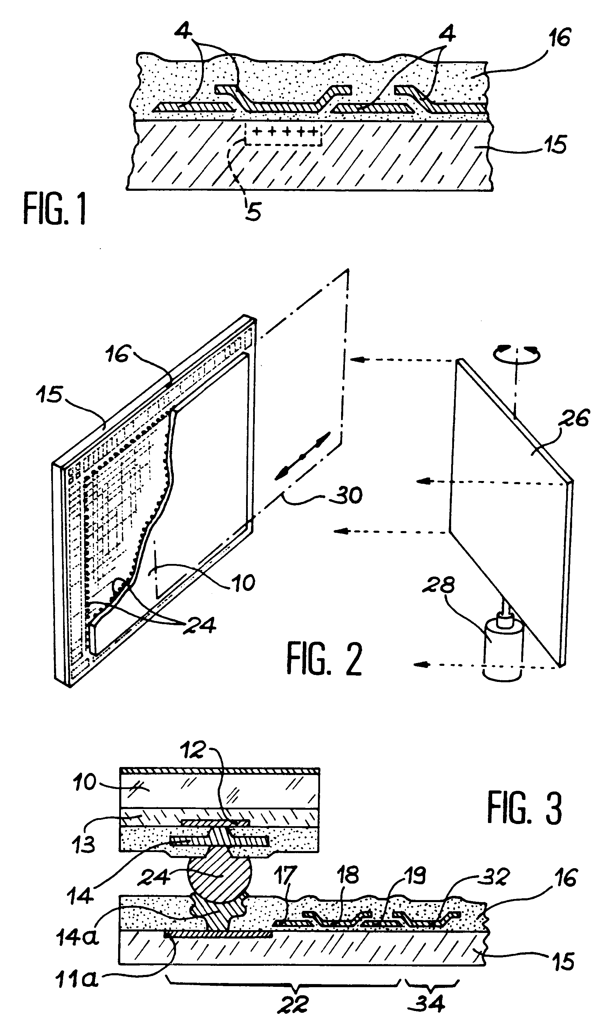

En référence à la figure 1, on rappelle brièvement le fonctionnement et la structure d'un DTC. Une couche isolante 16, par exemple en SiO₂, repose sur un substrat 15 semiconducteur, par exemple en Si. Des électrodes 4 couramment dénommées grilles, sont implantées à l'intérieur de la couche 16. Les bords d'une grille sur deux se superposent aux bords des grilles voisines.

Un potentiel de commande adéquat appliqué sur l'une de ces grilles 4 par l'intermédiaire de connexions non représentées modifie le potentiel à l'interface du semiconducteur et du diélectrique. A l'aplomb de la grille sélectionnée, le silicium est vidé de ses porteurs sur une épaisseur de quelques micromètres pour former une zone déplétée 5.

On comprend que par le jeu de potentiels adéquats appliqués sur les grilles 4, un ensemble de trois grilles permet la formation d'un puits de potentiel (localisé au niveau de la zone déplétée 5) qu'il est possible de remplir d'électrons.

Entre les différentes grilles, les marches de potentiel sont d'amplitude réglable par les potentiels de commande appliqués aux grilles.

Un ensemble de charges stockées dans un tel puits de potentiel peut être déplacé dans les différents étages du DTC délimités par les grilles ou même additionné à d'autres charges dans un étage, cela par l'application de potentiels de commande adéquats.

On verra dans la suite différents types d'utilisation de ces DTC.

En référence aux figures 2, 3 et 4, on donne maintenant une description d'un dispositif pour prises de vues à circuits de balayage intégrés conforme à l'art antérieur.

De manière connue, une image à enregistrer défile sur des détecteurs arrangés en matrice, perpendiculairement aux colonnes. A chaque prise de vue, les détecteurs fournissent des signaux représentatifs des éléments de l'image les ayant illuminés. Si une ligne comporte N détecteurs, au bout de N prises de vues, tous les détecteurs d'une ligne auront été parcourus par un même élément de l'image.

Les détecteurs d'une ligne sont reliés entre eux par un circuit de balayage des colonnes qui permet de collecter et d'additionner entre eux les signaux représentatifs du même élément de l'image, lors d'un défilement.

Un circuit de balayage des lignes relie les différents circuits de balayage des colonnes et assure le multiplexage des signaux qu'ils délivrent pour former un signal représentatif d'une colonne de l'image. L'image est donc délivrée en sortie du dispositif colonne par colonne.

L'opération d'addition des signaux représentatifs du même élément de l'image correspond à une moyenne qui améliore le rapport signal/bruit.

Pour obtenir un dispositif pour prises de vues compact et de faible consommation énergétique, les circuits de balayage des lignes et des colonnes sont réalisés par des structures de type DTC intégrées sur un même substrat.

La figure 2 est une vue d'ensemble de ce type de dispositif connu ; la figure 3 est une vue en coupe partielle montrant un ensemble de détection.

Un premier substrat 10 transparent aux rayonnements à détecter (par exemple en CdTe pour la détection infrarouge) supporte un ensemble de détecteurs 12 arrangés en lignes et en colonnes.

Une couche photosensible 13 (par exemple en HgCdTe pour la détection infrarouge) recouvre une face du substrat 10. Les détecteurs 12 sont constitués par des jonctions P-N incluses dans la couche 13. La référence 14 correspond à une prise de contact sur un détecteur.

Un second substrat, en regard du premier 10, supporte les dispositifs électroniques de lecture et balayage constitués par des DTC. Le substrat 15 semiconducteur, par exemple en silicium, est recouvert d'une couche isolante 16, par exemple en SiO₂, à l'intérieur de laquelle sont formées les électrodes 17, 18, 19, 32 réalisant les grilles des DTC.

Les grilles 17, 18, 19 délimitent trois étages du circuit de lecture 22 permettant l'intégration, pendant une durée de lecture déterminée, du signal électrique délivré par le détecteur 12 sous l'effet d'un éclairement. Une bille d'indium 24 assure, via les prises de contact 14 et 14a, la connexion entre le circuit de lecture 22 par l'intermédiaire d'une jonction 11a réalisée dans la couche 15 et le détecteur 12, disposés sur un substrat distinct. La grille 17 du premier étage du circuit de lecture 22 forme la grille d'un transistor MOS (dont la source est constituée par la jonction 11a et le drain par la zone déplétée sous la grille 18) et adapte l'impédance entre le détecteur 12 et le condensateur formé par le deuxième étage (grille 18). L'intégration est effectuée par ce deuxième étage. Le troisième étage (grille 19) fonctionne en interrupteur : ouvert pendant l'intégration, fermé pour délivrer le signal intégré au circuit de balayage décrit plus loin (la grille 32 représente une des grilles du circuit de balayage colonne). La commande des divers étages des circuits de lecture est obtenue grâce à des potentiels adéquats appliqués sur les différentes grilles 17, 18, 19.

Un système optique, principalement constitué par un miroir 26 animé d'un mouvement de rotation alternatif au moyen d'un moteur 28 permet de faire défiler une image 30 en translation sur les colonnes de détecteurs et perpendiculairement à celles-ci. Un défilement complet est effectué par exemple toutes les 40 ms pour respecter la production usuelle de signal vidéo.

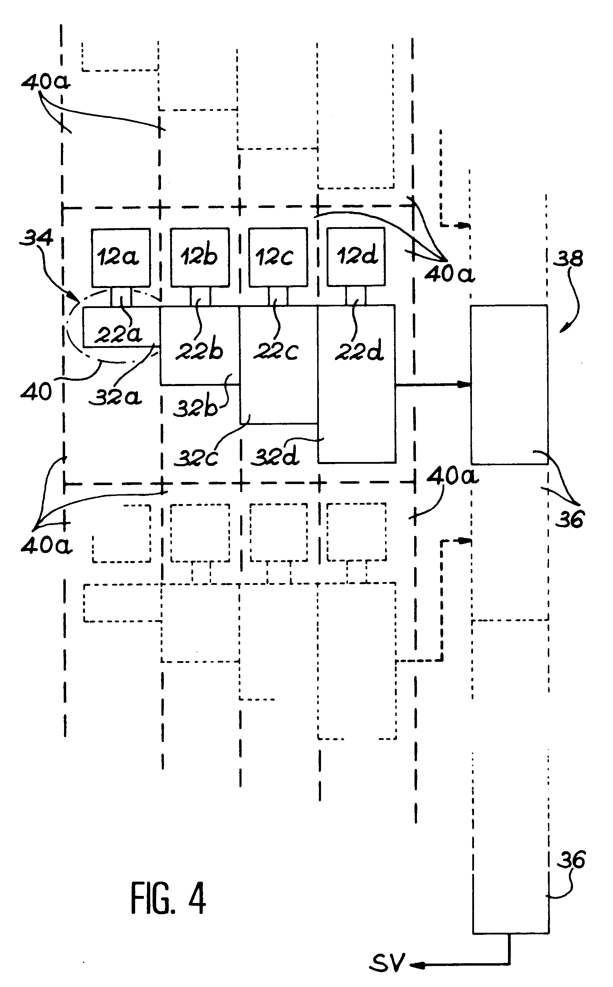

Le mode de fonctionnement de ce genre de dispositif sera plus facilement appréhendé en référence à la figure 4 représentant schématiquement une ligne de détecteurs reliée à ses circuits de balayage.

La ligne représentée est formée de quatre détecteurs 12a, 12b, 12c, 12d. Le circuit de balayage des colonnes est réalisé par un processeur 34 réalisant une fonction de retard et de sommation (processeur noté par la suite et usuellement désigné par les initiales TDI pour "time delay and integration", qualification anglosaxonne du processeur).

Dans ce type de dispositif, le processeur TDI est réalisé par des DTC : chaque grille du DTC forme un étage du processeur.

Chaque détecteur 12a, 12b, 12c, 12d est relié à un étage 32a, 32b, 32c, 32d du processeur 34 par l'intermédiaire d'un circuit de lecture 22a, 22b, 22c et 22d tel que décrit figure 3.

Lors d'un défilement d'une image, il y a autant de prises de vues (c'est-à-dire de lectures par les circuits de lecture 22a, 22b, 22c, 22d) que de colonnes de détecteurs.

La cadence des prises de vues est synchronisée avec la vitesse de défilement de l'image sur les colonnes de détecteurs : une prise de vue est déclenchée à chaque fois qu'un élément de l'image passe d'un détecteur à un autre détecteur de la même ligne. L'image peut, en effet, être découpée en autant d'éléments qu'il y a de zones de détection 40a, chaque zone de détection comportant un détecteur 12 et un circuit de détection 40 comprenant dans cette réalisation, un circuit de lecture 22 et un étage 32 du processeur TDI 34. La largeur d'un élément de l'image correspond donc à la largeur des zones de détection 40a.

Sur la figure 4, ainsi que sur les figures suivantes, on a représenté les détecteurs 12 dans le même plan que les circuits de détection 40 pour la commodité de la représentation. En réalité, comme on l'a vu figure 3, les détecteurs sont au-dessus des circuits de détection, ils sont disposés jointivement les uns par rapport aux autres, chaque détecteur étant situé pratiquement sur l'ensemble d'une zone de détection 40a, le circuit de détection associé étant situé sous le détecteur également dans cette zone.

Lors d'une prise de vue, pendant le temps de la lecture, chaque détecteur 12a, 12b, 12c, 12d délivre un signal électrique intégré par le circuit de lecture 22a, 22b, 22c, 22d auquel il est connecté. A la fin de la lecture, les signaux lus sont recopiés dans les différents étages 32a, 32b, 32c, 32d du processeur TDI 34 et additionnés aux signaux déjà présents dans ces étages correspondant aux prises de vues précédentes. Les signaux subissent ensuite un décalage vers l'étage suivant (décalage vers la droite dans l'exemple représenté : le signal contenu dans l'étage 32a est transféré dans l'étage 32b, celui contenu dans l'étage 32b est transféré en 32c, etc.).

Le processeur TDI 34 permet donc d'additionner entre eux les signaux provenant des différents détecteurs et représentatifs du même élément de l'image en train de défiler.

De cette manière, avant chaque prise de vue, l'étage 32a est vide ; l'étage 32b contient le signal enregistré par l'étage 32a lors de la dernière prise de vue et provenant du détecteur 12a ; l'étage 32c contient le signal enregistré par l'étage 32a lors de l'avant-dernière prise de vue additionné au signal enregistré par l'étage 32b lors de la dernière prise de vue ; l'étage 32d contient la somme des signaux provenant des étages 32a, 32b, 32c et enregistrés respectivement lors des avant avant dernière, avant-dernière et dernière prises de vues.

A la suite de chaque prise de vue, l'étage 32d contient un signal corespondant à la somme des signaux produits par les différents étages, chacun de ces signaux étant représentatif du même élément de l'image qui a défilé sur les détecteurs 12a, 12b, 12c, 12d successifs.

Lors du décalage, ce signal de somme est transféré de l'étage 32d vers un étage 36 d'un multiplexeur 38 qui délivre sur une sortie SV, les uns après les autres les signaux de somme provenant des différentes lignes. Le multiplexeur 38 présente usuellement une structure DTC et réalise le circuit de balayage des lignes.

Ainsi, à chaque prise de vue, le multiplexeur 38 délivre une suite de signaux représentative d'une colonne de l'image 30.

Les signaux provenant de chaque détecteur et représentatifs du même élément de l'image ne sont pas tout à fait identiques entre eux. En effet, la réponse de deux détecteurs à la même excitation présente de légères différences. En particulier, le bruit perturbant le signal délivré par chaque détecteur n'est pas le même. Mais, ces bruits parasites provenant de chacun des détecteurs sont décorrélés.

Du fait de la sommation des différents signaux provenant des détecteurs successifs appartenant à la même ligne, le signal délivré en sortie du processeur 34 est multiplié par un facteur 4 (ce facteur est égal à N pour une ligne de N détecteurs) alors que le bruit n'est multiplié que par un facteur 2 (√N pour une ligne de N détecteurs). Le rapport signal/bruit est donc amélioré d'un facteur 2 (√N pour une ligne de N détecteurs) par rapport à un dispositif ne présentant qu'une colonne de détecteurs (une ligne ne comportant qu'un unique détecteur).

D'autre part, la dispersion ligne à ligne, provenant du fait que les détecteurs ne sont pas rigoureusement identiques, est, elle aussi, moyennée par la sommation. Pour une ligne de N détecteurs, la dispersion est atténuée d'un facteur √N par rapport à un dispositif ne possédant qu'une colonne de détecteurs.

Ce type de dispositif souffre malgré tout de divers inconvénients.

La sensibilité du dispositif aux bruits parasites impose la proximité du processeur 34 et des détecteurs 12a, 12b, 12c, 12d, car la circulation des signaux dans des connexions, génératrice de bruit, doit être limitée au maximum.

Par ailleurs, pour obtenir la meilleure résolution spatiale possible, un circuit de détection 40 composé d'un circuit de lecture 22 et d'un étage 32 du processeur 34, doit avoir un encombrement inférieur ou égal aux dimensions d'une tache de diffraction dans la gamme de longueurs d'onde considérée, le détecteur associé devant couvrir les dimensions de la tâche de diffraction. Dans le cas d'une image infrarouge de longueur d'onde moyenne égale à 12 micromètres, le diamètre d'une tache de diffraction est d'environ 35 micromètres. Chaque circuit de détection 40 doit donc être contenu dans cette limite d'encombrement.

Or, on sait que l'encombrement d'un étage de processeur TDI augmente proportionnellement avec sa capacité à recevoir un grand nombre de charges électriques (signaux délivrés par les circuits de lecture). Ainsi, dans le dispositif de la figure 3, l'étage 32b présente une surface double de l'étage 32a, l'étage 32c une surface triple, etc... L'étage 32d présente la surface la plus importante, puisqu'il doit être à même de sotcker des charges provenant de chacun des détecteurs.

On comprend donc que le respect de l'encombrement pour conserver une résolution optimale lié à l'obligation de positionner le processeur à proximité des détecteurs entraîne une limitation du nombre d'étages successifs du processeur TDI et donc du nombre de détecteurs 12 formant une ligne (4 détecteurs par ligne dans l'art antérieur). L'amélioration du rapport signal/bruit, fonction du nombre de détecteurs, est donc elle aussi limitée.

La présente invention a pour objet un dispositif pour prises de vues à circuits de balayage intégrés acceptant un nombre très important de colonnes de détecteurs et permettant ainsi de sommer un grand nombre de signaux représentatifs du même élément de l'image pour obtenir un signal représentatif de l'image globale avec un excellent rapport signal/bruit tout en respectant des critères topographiques pour conserver une résolution optimale.

Un autre but de l'invention est de fournir un dispositif n'ayant qu'une consommation électrique réduite.

L'invention préconise par ailleurs, d'utiliser deux sens de défilement de l'image sur les colonnes de détecteurs, ce qui permet d'éliminer le temps mort que constituait le retour du miroir à sa position initiale dans les dispositifs selon l'art antérieur.

De façon plus précise, la présente invention concerne un dispositif pour prises de vues à circuits de balayage intégrés comprenant :
plusieurs détecteurs arrangés en lignes et en colonnes, ces détecteurs délivrant un signal électrique proportionnel à leur éclairement,
un système optique apte à faire défiler une image en translation sur les colonnes de détecteurs, perpendiculairement à celles-ci,
plusieurs circuits de lecture ayant une structure de type "dispositif à transfert de charges" intégrés sous les détecteurs, connectés chacun à un détecteur, chaque circuit de lecture étant apte à effectuer une lecture du signal électrique délivré par le détecteur auquel il est connecté, en relation avec le défilement de l'image et délivrant un signal de lecture,
pour chaque ligne, un circuit de balayage des colonnes ayant une structure de type DTC apte à additionner les signaux de lecture correspondant à la détection d'un même élément de l'image défilant successivement sur les détecteurs d'une même ligne, et délivrant des signaux représentatifs des éléments de l'image ayant défilé sur tous les détecteurs d'une ligne,
un circuit de balayage des lignes constitué d'un multiplexeur de lignes ayant une structure de type DTC et possédant autant d'étages qu'il y a de lignes de détecteurs, chaque étage étant relié à un circuit de balayage des colonnes, ce multiplexeur délivrant un signal représentatif d'une colonne de l'image formé par les différents signaux délivrés par les circuits de balayage des colonnes,
caractérisé en ce que, le système optique étant apte à faire défiler l'image selon un ou deux sens de défilement opposés successifs, les circuits de balayage des colonnes sont aptes à additionner les signaux de lecture correspondant à la détection d'un même élément de l'image défilant successivement sur les détecteurs d'une même ligne et délivrent des signaux représentatifs des éléments de l'image ayant défilé sur tous les détecteurs d'une même ligne dans l'un et/ou l'autre sens, une partie de chaque circuit de balayage étant intégrée sous les détecteurs de la ligne correspondante et l'autre partie étant intégrée à côté de ladite ligne selon un pas inférieur ou égal au pas des lignes de détecteurs.

La répartition topographique des différentes fonctions du circuit de balayage colonnes permet d'avoir des circuits de détection (constitués dans le cas de l'invention par les circuits de lecture et par la partie des circuits de balayage colonnes intégrée sous les détecteurs) de taille identique entre eux et inférieure ou égale à la limite d'encombrement (par exemple 35 »m). De cette façon, le nombre de détecteurs par ligne n'est pas limité, les détecteurs d'une même colonne étant en outre pratiquement jointifs pour éviter les zones de détection inactives. Par ailleurs, le reste de chaque circuit de balayage colonnes étant intégré à côté des détecteurs avec un pas inférieur ou égal au pas d'une ligne de détecteurs, les lignes de détecteurs peuvent être effectivement positionnées jointivement sans zones aveugles. En outre, plusieurs matrices de détection (par exemple de 512 lignes et 32 colonnes) peuvent être assemblées jointivement pour obtenir une matrice de grande complexité (par exemple de 4096 lignes et 32 colonnes) sans zone de détection morte.

On entend par circuit intégré à côté des détecteurs, un circuit intégré à proximité des détecteurs mais pas forcément dans le même plan. En effet, en réalité les circuits de balayage colonnes sont intégrés dans le plan des circuits de lecture.

Selon la présente invention, N étant le nombre de détecteurs formant une ligne, chaque circuit de balayage des colonnes comporte :
un multiplexeur colonnes comportant N étages intégré sous les détecteurs de la ligne correspondante, chaque étage étant relié à un circuit de lecture, ce multiplexeur étant apte à recopier dans ses différents étages les signaux de lecture formés après une prise de vue, et à délivrer sur une sortie (SM) en multiplexage ces signaux de lecture,
au moins un processeur intégré à côté des détecteurs de la ligne correspondante pour traiter les signaux délivrés par le multiplexeur colonnes et réalisant une fonction de retard et de sommation, ce processeur délivrant sur au moins une sortie des signaux représentatifs des éléments formant une ligne de l'image, chacun de ces signaux étant constitué par la somme des signaux correspondant au même élément de l'image ayant défilé sur tous les détecteurs d'une ligne,
pour chaque processeur, un circuit de commande connecté à une sortie du multiplexeur colonnes et à une entrée du processeur, ce circuit étant apte à autoriser ou interdire un transfert de signaux entre lesdits multiplexeur et processeur.

Le circuit de commande est intégré sous les détecteurs et/ou à côté de ceux-ci indifféremment.

Selon un mode de réalisation particulier, le processeur comporte au moins 2N étages répartis en un étage central dans lequel sont effectuées les sommations relié à une première succession comportant au moins N-1 étages et à une seconde succession comportant au moins N étages, le circuit de commande étant relié audit étage central.

Selon une variante de réalisation, les étages de chaque processeur présentent une forme de bande allongée selon l'alignement d'une ligne de détecteurs, les successions d'étages étant disposées de part et d'autre de l'étage central perpendiculairement à l'alignement de la ligne de détecteurs mais dans le pas des lignes de détecteurs.

Selon un mode de réalisation particulier de cette variante, pour chaque processeur un interrupteur ayant une structure de type DTC relie l'étage central à un étage du multiplexeur de lignes.

Selon une autre variante de réalisation, la seconde succession comporte N+1 étages et les signaux représentatifs des éléments successifs formant une ligne de l'image sont délivrés en sortie de l'un ou l'autre des étages extrêmes des successions en relation avec le sens de défilement de l'image, lesdits étages extrêmes étant reliés à un étage du multiplexeur de lignes.

Dans une réalisation de cette autre variante, le circuit de commande comporte un convertisseur de charges en tension connecté à la sortie (SM) du multiplexeur colonnes et un convertisseur de tension en charges connecté à l'étage central du processeur.

Selon une variante de réalisation, chaque processeur présente une forme en U, les deux successions d'étages formant les branches du U, étant parallèles entre elles et à côté (de façon préférentielle dans l'alignement) d'une ligne de détecteurs, l'étage central formant la base du U.

Dans ce mode, préférentiellement, les successions comportent chacune N+1 étages.

Dans ce mode de réalisation, préférentiellement, pour chaque processeur les étages extrêmes des successions sont reliés à des interrupteurs ayant une structure de type DTC, chacun de ces interrupteurs étant relié au même étage du multiplexeur de ligne.

Selon une variante de réalisation, le circuit de commande présente une structure de type DTC à un étage et constitue un interrupteur.

Dans cette variante, préférentiellement, chaque étage du processeur est au moins N fois plus étendu qu'un étage du multiplexeur colonnes.

Dans une autre variante de réalisation, le circuit de commande présente une structure de type DTC à trois étages dont un étage réalise un condensateur de capacité Cs et est relié à la sortie du multiplexeur colonnes, un autre étage réalise un condensateur de capacité Cp et est relié à l'étage central du processeur et un autre étage constituant un interrupteur, ce circuit de commande constituant un interrupteur réalisant les fonctions d'ébasage et de partition des charges issues du multiplexeur colonnes.

Dans cette variante, préférentiellement, chaque étage du processeur est au moins N(Cs/(Cs+Cp)) fois plus étendu qu'un étage du multiplexeur.

De toute façon, les caractéristiques et avantages de l'invention appraîtront mieux après la description qui suit donnée à titre explicatif et nullement limitatif. Cette description se réfère à des dessins annexés, sur lesquels :
- la figure 1, déjà décrite, représente schématiquement une vue en coupe d'une structure de type DTC,
- la figure 2, déjà décrite, représente schématiquement une vue d'ensemble d'un dispositif pour prises de vues conforme à l'art antérieur,
- la figure 3, déjà décrite, représente schématiquement une vue en coupe partielle du précédent dispositif,
- la figure 4, déjà décrite, représente schématiquement une ligne de détecteurs reliée à ses systèmes de balayage conforme à l'art antérieur,
- la figure 5 représente schématiquement une vue partielle d'une première variante de réalisation d'un dispositif pour prises de vues selon l'invention,
- la figure 6 représente schématiquement un ensemble réalisant une double conversion charges/tension puis tension/charges utilisé dans la première variante,
- les figures 7A et 7B représentent schématiquement le fonctionnement d'un circuit de balayage des colonnes pour un dispositif conforme à la première variante, selon les deux sens de défilement,
- la figure 8 représente schématiquement une vue partielle d'une seconde variante de réalisation d'un dispositif pour prises de vues conforme à l'invention,
- la figure 9 représente schématiquement un premier mode de réalisation d'un circuit de commande,
- la figure 10 représente schématiquement un second mode de réalisation d'un circuit de commande,
- la figure 11 représente schématiquement les potentiels de commande permettant les différents transferts des signaux entre les étages du multiplexeur et du processeur,
- la figure 12 représente schématiquement une vue partielle d'une troisième variante de réalisation d'un dispositif pour prises de vues conforme à l'invention.

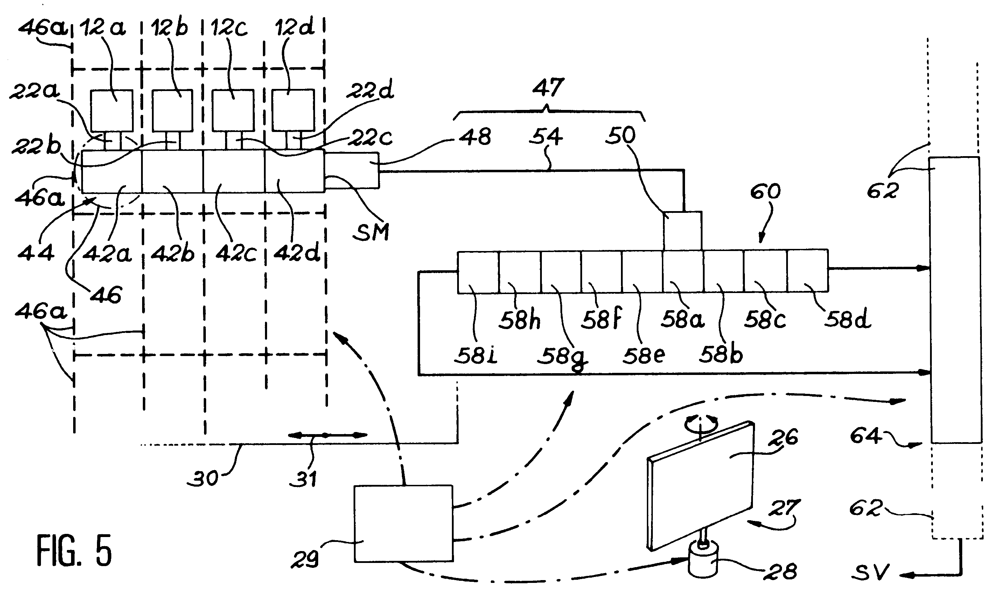

La figure 5 représente schématiquement et partiellement un dispositif pour prises de vues à circuits de balayage intégrés selon l'invention.

Les détecteurs sont arrangés en lignes et en colonnes. Ils sont supportés par un premier substrat (non représenté) et reliés à des circuits de lecture et de balayage intégrés sur un second substrat (non représenté). Pour la clarté de la description, dans l'exemple présenté, une ligne de détecteurs est composée de quatre détecteurs 12a, 12b, 12c, 12d, mais cette quantité n'est pas limitative. A titre indicatif, un tel dispositif conforme à l'invention peut posséder par exemple 512 lignes de 32 détecteurs.

Un système optique 27 principalement composé d'un miroir 26 mû en rotation selon deux sens alternatifs par un moteur 28 permet le défilement d'une image 30 en translation sur les colonnes de détecteurs, perpendiculairement à celles-ci et selon deux sens de défilement opposés successifs. Eventuellement une optique de focalisation (non représentée) permet d'ajuster les dimensions de l'image 30 à celles de la matrice de détecteurs.

Une double flèche 31 symbolise les deux sens de défilement de l'image 30.

Les détecteurs 12a, 12b, 12c, 12d d'une ligne sont respectivement connectés aux circuits de lecture 22a, 22b, 22c, 22d.

Les circuits de lecture d'une ligne sont connectés au circuit de balayage des colonnes. Conformément à l'invention, pour chaque ligne, ce dernier additionne les signaux de lecture correspondant à la détection d'un même élément de l'image ayant défilé successivement sur les détecteurs de la ligne dans l'un ou l'autre sens, et délivre des signaux sommés représentatifs des éléments successifs formant une ligne de l'image.

Un circuit de balayage des lignes fournit un signal représentatif de chaque image ayant défilé sur les détecteurs dans l'un ou l'autre sens à partir des signaux délivrés par les circuits de balayage des colonnes.

L'ensemble de la circuiterie, c'est-à-dire les différents éléments intégrés sur le second substrat, est avantageusement réalisé à partir de structures de type TDC. Un circuit de commande générale 29, connecté aux grilles des différents éléments permet l'application des potentiels adéquats pour le fonctionnement du dispositif.

Chaque circuit de balayage des colonnes comporte un multiplexeur 44, un processeur TDI 60 réalisant une fonction de retard et de sommation, et un circuit de commande 47 relié à une sortie du multiplexeur 44 et à une entrée du processeur 60.

Pour chaque ligne, les circuits de lecture 22a, 22b, 22c, 22d sont respectivement connectés aux étages 42a, 42b, 42c, 42d du multiplexeur 44. Ce dernier comporte au moins autant d'étages qu'il y a de détecteurs.

Un circuit de lecture et un étage du multiplexeur forment un circuit de détection 46 d'encombrement réduit par rapport aux circuits de détection des dispositifs selon l'art antérieur. Chaque circuit de détection est intégré dans une zone de détection 46a, sous le détecteur 12 qui lui est associé.

Les étages des multiplexeurs ne devant recevoir que les charges provenant d'un seul détecteur à la fois, ont tous une surface identique et qui ne limite pas l'implantation d'un grand nombre de détecteurs sur une ligne tout en respectant les critères de résolution optimale.

Quel que soit le sens de défilement de l'image 30, à chaque prise de vue, les signaux délivrés par les détecteurs 12a, 12b, 12c, 12d sont enregistrés par les étages correspondants 42a, 42b, 42c, 42d du multiplexeur 44. Ces signaux sont ensuite multiplexés sur la sortie SM du multiplexeur 44. Ils sont transférés au processeur 60 réalisant une fonction de retard et de sommation (processeur TDI) par l'intermédiaire d'un circuit de commande 47 apte à autoriser ou interdire un transfert de signaux entre le multiplexeur 44 et le processeur 60.

Dans cette variante de réalisation, le circuit de commande 47 comprend un convertisseur de charges en tension 48 connecté par une connexion 54 à un convertisseur de tension en charges 50.

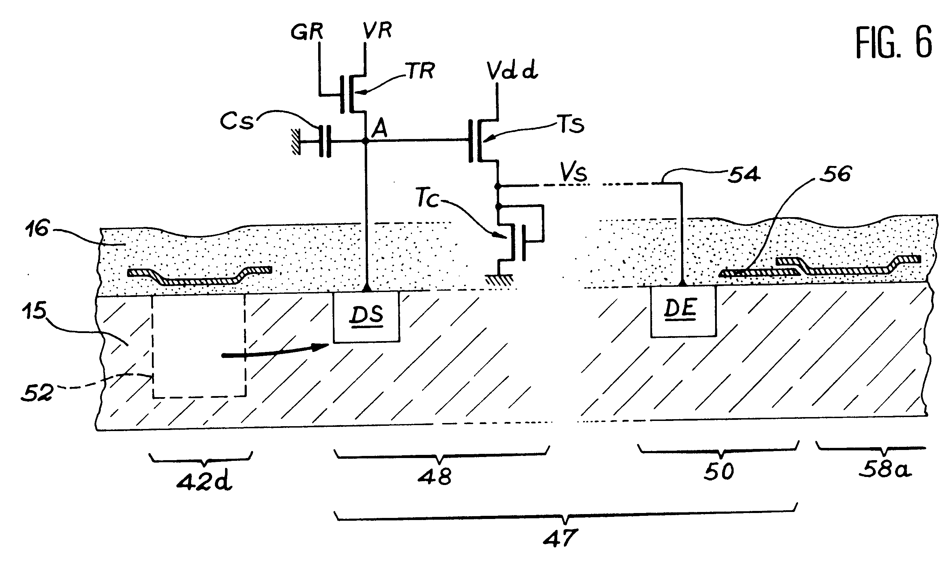

La figure 6 représente schématiquement un exemple de réalisation de ces convertisseurs. Les charges contenues dans la zone déplétée 52 du dernier étage 42d du multiplexeur sont transférées dans une diffusion DS, sous l'action d'un potentiel de commande adéquat appliqué sur la grille de cet étage. Celle-ci (DS) est réalisée par diffusion ou implantation locale d'impuretés dans la couche 15 de manière à obtenir une diode.

Au point A sont connectés par des lignes de connexion : la diffusion DS, un condensateur CS porté par ailleurs à la masse et un ensemble de deux transistors TMOS TR et TS permettant une adaptation d'impédance entre la diffusion DS et une diffusion DE. TS est alimenté en permanence à un potentiel Vdd alors que TR est alimenté par un potentiel VR et commandé par un potentiel GR appliqué sur sa grille. Une tension VS proportionnelle à la variation de charges dans CS est délivrée par la source de TS.

Un troisième transistor TMOS TC joue le rôle de charge ohmique. Il est connecté à la source de TS.

Les transistors TR, TS et TC ainsi que CS constituent un étage de sortie classique d'un dispositif à transfert de charges dont la figure 6 donne une représentation électrique. L'ensemble TS et TC constitue un étage suiveur de gain proche de 1.

Par l'intermédiaire d'une connexion 54, la tension VS est appliquée sur la diffusion DE réalisée dans la couche 15. La grille 56 réalisée dans la couche 16 délimite un étage fonctionnant en interrupteur commandé par application d'un potentiel adéquat.

La diffusion DE et l'étage, délimité par la grille 56, associé à l'étage d'entrée 58a du processeur forment le convertisseur de tension en charges 50. La diffusion DS et l'étage de sortie (TR, TS, TC, CS) forment le convertisseur charges/tension 48.

Comme on le verra plus loin, les charges produites par le convertisseur 50 sont stockées dans l'étage 58a d'un processeur 60 réalisant les fonctions de retard et de sommation.

La grille de l'étage 58a étant corectement polarisée, l'interrupteur associé à la grille 56 est alors fermé. Le potentiel de surface sous la grille de l'étage 58a est imposé par le potentiel VS de la diffusion DE et lorsque l'interrupteur est ouvert à nouveau, la quantité de charges stockées dans l'étage 58a est proportionnelle à VS.

Dans ce montage, TR fonctionne comme un interrupteur et permet sous l'action de la commande GR la repolarisation (ou réinitialisation) de CS au potentiel VR après que la variation de tension liée à l'afflux des charges provenant du multiplexeur ait été prise en compte par l'interrupteur associé à la grille 56.

Les convertisseurs 48 et 50 sont réalisés dans des technologies permettant leur intégration sur le substrat semiconducteur 15.

La double conversion permet le transfert des signaux du multiplexeur vers le processeur dans des conditions optimales. En effet, une simple conduction de la charge de DS vers DE par une connexion de type "métallique" perturberait de manière trop importante les signaux transférés par l'introduction de bruit parasite.

De nouveau en référence à la figure 5, on va maintenant décrire le fonctionnement du balayage des charges produites par les détecteurs 12a, 12b, 12c, 12d d'une ligne.

Une fois délivrés par les circuits de lecture 22a à 22d aux étages 42a à 42d, respectivement, du multiplexeur 44, les signaux de lecture sont multiplexés en sortie SM du multiplexeur. Le circuit de commande 47 fonctionnant en interrupteur fermé et réalisant une double conversion charges/tension, tension/charges permet leur transfert dans l'étage 58a du processeur 60.

Le processeur 60 possède une structure de type DTC et comprend, dans l'exemple représenté, 9 étages. Pour une ligne de N détecteurs, le processeur 60 comprendrait 2N+1 étages.

Les étages du processeur sont répartis en une première succession de trois étages (N-1 pour une ligne de N détecteurs) 58b, 58c, 58d et en une seconde succession de cinq étages 58e, 58f, 58g, 58h, 58i (N+1 pour une ligne de N détecteurs) reliées à un étage central 58a. Comme on le verra plus loin les opérations de sommation sont réalisées dans l'étage central 58a.

L'encombrement de chaque étage du processeur 60 est le même : la surface de ses grilles est quatre fois (N fois pour une ligne de N détecteurs) celle d'une grille du multiplexeur 44.

Le processeur 60 est commandé par des potentiels de commande adéquats appliqués sur les grilles des différents étages 58a à 58i.

Les opérations effectuées par le processeur 60 dépendent du sens de défilement de l'image 30 sur les colonnes de détecteurs.

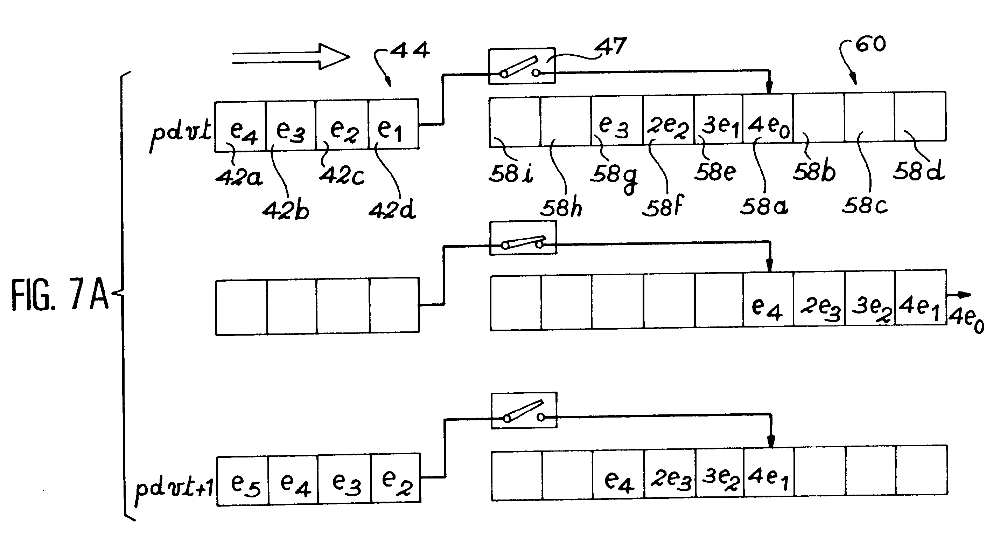

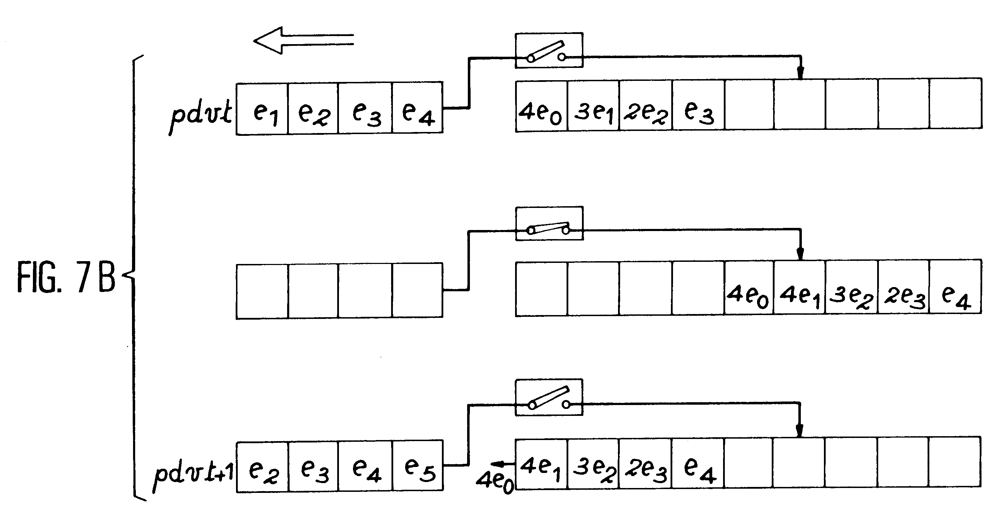

On comprendra mieux le fonctionnement du dispositif de la figure 5, en référence aux figures 7A et 7B représentant schématiquement les remplissages du multiplexeur 44 et des étages du processeur 60 au cours du temps.

La figure 7A représente les états successifs du multiplexeur 44 et du processeur 60 lorsque l'image défile du détecteur 12a vers le détecteur 12d. Le sens de défilement est rappelé par une flèche ; il est qualifié de sens aller.

A la suite d'une prise de vue notée pdvt, les étages du multiplexeur 44 sont remplis avec les signaux e1, e2, e3, e4 représentatifs des éléments de l'image, ces derniers ayant été respectivement détectés par les détecteurs 12d, 12e, 12b, 12a.

On note que pendant la prise de vue, le circuit de commande 47 fonctionne en interrupteur ouvert.

L'étage 58g du processeur 60 contient un signal noté aussi e3 car il est représentatif du même élément de l'image que celui détecté par le détecteur 12b au temps pdvt. Ce signal a été enregistré au cours de la prise de vue précédente et est issu de la détection effectuée par le détecteur 12a.

L'étage 58f contient le signal noté 2e2 somme des signaux e2 représentatifs des éléments de l'image enregistrés au cours des deux prises de vues précédentes et issus des détecteurs 12a et 12b.

Suivant la même notation, les étages 58c et 58a contiennent les signaux 3e1 et 4e0.

Lors de l'opération de multiplexage, le circuit 47 fonctionne en interrupteur fermé ; les signaux e1 à e4 sont transférés par 4 décalages (N décalages pour N détecteurs) successifs dans les étages 58a à 58d du processeur 60. Les signaux contenus dans le processeur 60 sont décalés de façon synchrone de manière qu'à chaque passage d'un des signaux e3, 2e2, 3e1 par l'étage 58a, celui-ci soit additionné au signal (respectivement e3, e2, e1) représentatif du même élément de l'image provenant du multiplexeur.

Le signal 4e0 somme des quatre signaux représentatifs de l'élément de l'image ayant défilé sur tous les détecteurs de la ligne considérée, est délivré à l'extérieur du processeur 60 en sortie de l'étage 58d.

Le circuit de commande 47 fonctionne alors en interrupteur ouvert, et la prise de vue suivante pdvt+1 est effectuée ainsi que le remplissage du multiplexeur avec les signaux représentatifs des éléments de l'image détectés.

Pendant la durée de la prise de vue, les signaux e4, 2e3, 3e2, 4e1 subissent trois décalages (N-1 décalages si il y a N détecteurs) de manière à occuper respectivement les étages 58g, 58f, 58e et 58a du processeur 60.

Ces étapes successives se répètent pendant le défilement complet de l'image dans le sens aller.

La figure 7B représente l'état du multiplexeur 44 et du processeur 60 lorsque l'image défile du détecteur 12d vers le déteceur 12a. Le sens de défilement est rappelé par une flèche ; il est qualifié de sens retour.

Deux prises de vues successives sont indiquées, notées comme précédemment pdvt et pdvt+1.

Lors de la prise de vue pdvt et du remplissage des étages du multiplexeur 44 avec les signaux e1, e2, e3, e4 représentatifs des éléments de l'image détectés par les détecteurs respectifs 12a à 12d, les signaux 4e0, 3e1, 2e2, e3 sont respectivement positionnés dans les étages 58i, 58h, 58g et 58f du processeur 60.

Lors du multiplexage, au cours de quatre décalages (N décalages pour une ligne de N détecteurs) successifs des signaux contenus dans le multiplexeur et de ceux contenus dans le processeur, l'addition des signaux représentatifs des mêmes éléments de l'image s'effectue dans l'étage 58a. A la fin du multiplexage, les signaux sont positionnés dans les étages 58e, 58a, 58b, 58c, 58d.

Au cours de la prise de vue pdvt+1 et du remplissage des étages du multiplexeur 44 avec les signaux représentatifs des éléments e5, e4, e3, e2 de l'image, les signaux contenus dans le processeur 60 subissent cinq décalages (N+1 décalages pour une ligne de N détecteurs) pour remplir les étages 58i à 58f. Lors de cette opération, le signal 4e₀ est délivré en sortie de l'étage 58i.

Ces opérations se répètent pendant tout le défilement dans le sens retour de l'image.

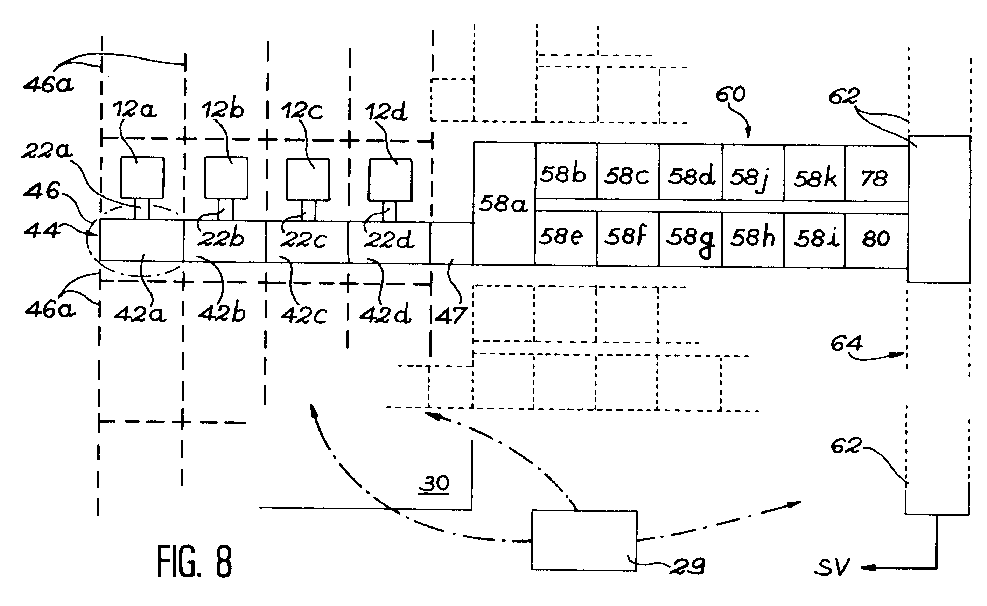

De nouveau en référence à la figure 5, on voit que les étages 58i et 58d du processeur 60 sont connectés à un étage 62 d'un multiplexeur de ligne 64. Chacune de ces connexions est assurée soit au moyen d'une double conversion charges/tension, tension/charges du même type que le convertisseur 47, dans le cas d'une connexion longue (notamment pour l'étage 58i dans le cas de la figure 5) soit au moyen d'un interrupteur du même type que les interrupteurs 78 et 80 décrits en référence à la figure 8 pour les étages extrêmes adjacents au multiplexeur 64 (notamment pour l'étage 58d dans le cas de la figure 5).

Suivant le sens aller ou retour du défilement de l'image, à chaque prise de vue, chaque étage 58d ou 58i des processeurs 60 associés aux différentes lignes délivre un signal constitué par la somme des signaux représentatifs d'un élément de l'image ayant défilé sur tous les détecteurs d'une ligne. Ce signal est enregistré dans un étage du multiplexeur de ligne 64.

Ensuite, les divers signaux sont multiplexés en sortie SV du multiplexeur de ligne 64 qui fournit ainsi à chaque prise de vue un signal représentatif d'une colonne de l'image ayant défilé sur les détecteurs.

La figure 8 représente schématiquement une vue partielle d'une autre variante de réalisation d'un dispositif selon l'invention. Le dispositif ne comprend de manière non limitative que quatre colonnes de détecteurs pour simplifier la description. Les circuits de détection 46 sont identiques à ceux de la première variante.

Le processeur 60 présente ici une forme en U. Il possède onze étages (2N+3 étages pour une ligne de N détecteurs) répartis en un étage central 58a dans lequel s'effectuent les additions et deux successsions de cinq étages (N+1 étages pour une ligne de N détecteurs) respectivement 58b, 58c, 58d, 58j, 58k et 58e, 58f, 58g, 58h, 58i. De façon générale, le circuit 29 commande les grilles des dispositifs de type DTC par l'intermédiaire de lignes de commande non représentées, chaque ligne de commande étant reliée à plusieurs grilles de DTC. Par exemple, pour un DTC à 4 phases, 4 lignes de commande sont nécessaires, chaque ligne étant connectée à une grille sur 4 du DTC. Ainsi, sur la figure 8, les étages 58a, 58h et 58j sont commandés par la même ligne.

L'étage central 58a forme la base du U auquel sont connectées les deux successions. Celles-ci forment les branches du U parallèles entre-elles et disposées à côté et de façon préférentielle dans le prolongement de la ligne de détecteurs.

De cette manière, le processeur 60 ne déborde pas du pas vertical de la zone de détection.

Dans cette réalisation, les étages de sortie 58i et 58k sont reliés par l'intermédiaire d'interrupteurs respectivement référencés 80 et 78 à un étage 62 du multiplexeur de ligne 64.

L'ajout des étages 58j, 58k par rapport à la réalisation précédente, permet de symétriser le nombre d'étages de chaque branche de U pour des raisons de topographie. Aucune connexion de type "métallique", source de bruit supplémentaire, n'est nécessaire.

L'ouverture et la fermeture des interrupteurs 78, 80 sont fonction du sens de défilement de l'image 30 sur les colonnes de détecteurs.

Comme on va le voir dans la suite de la description, la surface des étages dépend du mode de réalisation du circuit de commande 47.

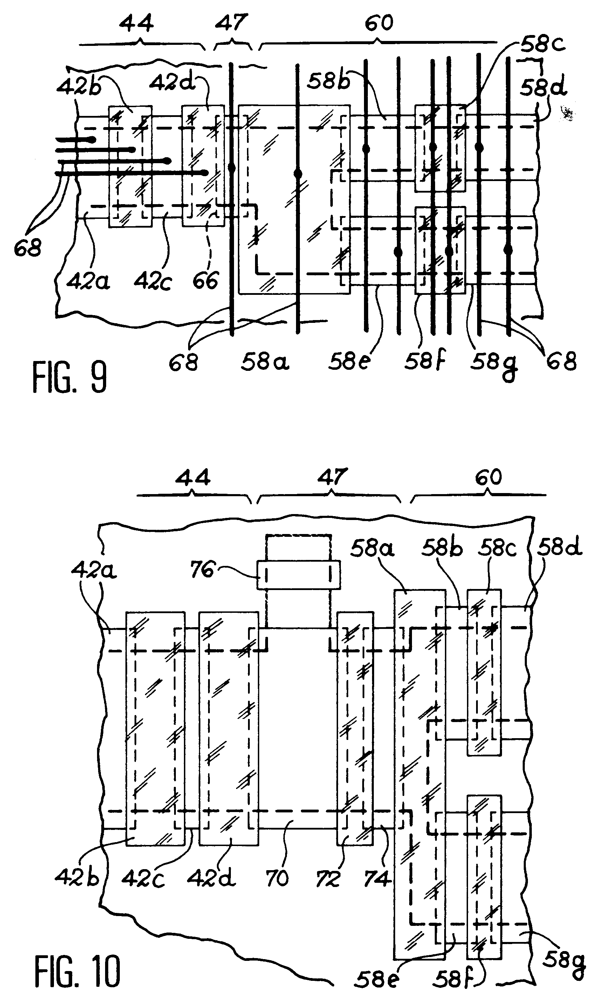

La figure 9 représente schématiquement un premier mode de réalisation du circuit de commande 47 utilisé dans cette variante.

Dans cette version, le circuit de commande 47, ayant une structure de type DTC, ne possède qu'un étage.

Sur cette vue, seules sont représentées les grilles 42a, 42b, 42c, 42d du multiplexeur 44, la grille 66 correspondant à l'étage du circuit de commande, les grilles 58a, 58b, 58c, 58d, 58e, 58f, 58g du processeur 60 et les connexions 68 reliant les différentes grilles au circuit de commande générale 29. Ces dernières sont par exemple en aluminium.

Dans cette réalisation, le circuit de commande 47 réalise seulement une fonction d'interrupteur ouvert ou fermé suivant le potentiel de commande appliqué sur la grille 66. Il est à même d'enregistrer et de transférer dans l'étage 58a du processeur 60, les charges électriques délivrées par l'étage 42d du multiplexeur 44.

Le schéma de la figure 9 n'est pas représenté à l'échelle ; en effet dans cette configuration les grilles du processeur possèdent une surface au moins quatre fois plus importante (N fois plus importante pour une ligne de N détecteurs) que la surface d'une grille du multiplexeur.

La figure 10 représente schématiquement un second mode de réalisation du circuit de commande 47 réalisant les fonctions d'ébasage et de partition utilisé dans la variante de la figure 8.

Dans cette version, le circuit de commande 47, ayant une structure de type DTC, possède trois étages délimités par les grilles 70, 72, 74.

Le premier étage (grille 70) constitue un premier condensateur de capacité Cp ; le second étage (grille 72) constitue un interrupteur ; le troisième étage (grille 74) constitue un second condensateur de capacité CS. Cet ensemble permet de ne déliver à l'étage 58a qu'une fraction Cs/(Cp+Cs) de la quantité de charges provenant de l'étage 42d. De cette manière la surface des grilles du processeur 60 peut être réduite à N(Cs/(Cp+Cs)) fois la surface d'une grille du multiplexeur 44, lorsqu'une ligne comprend N détecteurs.

Le circuit de commande comprend encore une grille 76 constituant un transistor dont la source (non représentée) est polarisée en permanence à un potentiel VR et dont la grille 76 est soumise à un potentiel GR permettant une réinitialisation, c'est-à-dire la mise au potentiel VR du premier condensateur après le transfert des charges dans l'étage 58a.

Cette réalisation ne comporte aucune connexion de type "métallique" et, d'autre part, ne nécessite pas de double conversion charges/tension, tension/charges. Deux sources importantes de bruit sont ainsi éliminées. En outre, elle permet de réduire la consommation électrique par rapport aux réalisations avec double conversion.

Lorsque l'image défile dans le sens aller, l'interrupteur 78 est fermé alors que l'interrupteur 80 est ouvert. A la suite d'une prise de vue, les signaux contenus dans les étages du multiplexeur 44 et du processeur 60, subissent quatre décalages (N décalages pour une ligne de N détecteurs) qui permettent le vidage du multiplexeur 44 et les opérations d'addition au passage de l'étage 58a du processeur.

A la suite de ces quatre décalages, les signaux contenus dans le processeur 60 subissent deux décalages supplémentaires : cela a pour effet de permettre la délivrance à l'étage 62 du multiplexeur 64 (voir figure 8) par l'étage 58k du signal constitué par la somme des signaux représentatifs d'un élément de l'image ayant défilé sur toutes les colonnes de détecteurs.

Les signaux contenus dans le processeur 60 subissent alors cinq décalages en sens inverse (N+1 pour une ligne de N détecteurs) pour remplir les étages 58a, 58e, 58f, 58g. Ces cinq décalages sont effectués pendant la prise de vue suivante afin d'éliminer tout temps mort.

Lorsque l'image défile dans le sens retour, l'interrupteur 80 est fermé et l'interrupteur 78 est ouvert.

A la suite d'une prise de vue, les signaux contenus dans les étages du multiplexeur 44 et du processeur 60 subissent quatre décalages (N pour une ligne de N détecteurs).

A la suite de ces quatre décalages, les signaux contenus dans le processeur 60 subissent cinq décalages en sens inverse (N+1 pour une ligne de N détecteurs) pour remplir les étages 58f, 58g, 58h, 58i. Le signal devant être délivré l'est par l'étage 58i. Cette deuxième série de décalages est effectuée pendant la prise de vue suivante.

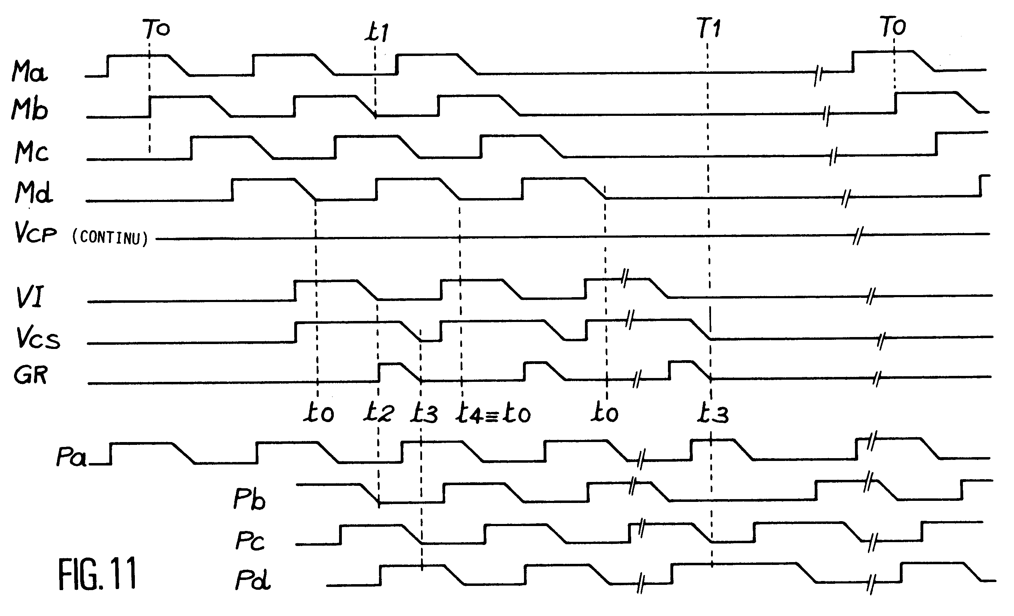

Le mode de fonctionnement du dispositif comportant un circuit de commande 47 à trois étages sera mieux compris en référence à la figure 11 qui représente schématiquement une séquence de potentiels appliqués sur les différentes grilles à la suite d'une prise de vue pour obtenir le transfert et l'addition d'un signal dans l'étage 58a.

Ma, Mb, Mc, Md sont les potentiels appliqués sur les grilles 42a, 42b, 42c, 42d du multiplexeur 44.

VCp, VI, VCs et GR sont les potentiels appliqués sur les grilles 70, 72, 74 et 76 du circuit de commande 47.

Pa, Pb, Pc, Pd sont les potentiels appliqués sur les grilles 58a, 58b, 58c, 58d du processeur 60 (les grilles 58i et 58k étant commandées comme on l'a vu précédemment conjointement à 58a et 58b).

Dans cet exemple, les grilles sont activées pour les valeurs positives des signaux.

Au temps T0, les charges provenant des circuits de lecture 22 sont injectées dans les étages du multiplexeur 44.

Au temps t0, les charges contenues dans l'étage 42d sont injectées dans le circuit de commande 47.

Au temps t1, les charges contenues dans la dernière grille 58k sont injectées dans un étage 62 du multiplexeur 64 au travers de l'étage 78 (voir figure 8).

Simultanément, au temps t2 =t1, l'opération de partition est effectuée en isolant la grille 74 du reste du circuit de commande 47.

Au temps t3, le premier condensateur du circuit 47 (grille 70) est réinitialisé ; les charges contenues dans le second condensateur (grille 74) sont transférées dans l'étage 58a.

Au temps t4, les charges ont progressé d'un étage dans le multiplexeur 44 et dans le processeur 60. t4 correspond au temps t0 d'une nouvelle séquence permettant la progression des charges d'un étage.

Au temps T1, toutes les sommations ont été réalisées ; le sens de propagation des charges dans le processeur 60 est inversé en modifiant les formes d'onde des commandes du processeur 60. Entre T1 et T0, les décalages en sens inverse sont effectués dans le processeur 60.

A partir de T1 et jusqu'au temps T0 suivant le circuit 29 gèle les signaux de commande du multiplexeur 44 et du circuit de commande 47 : ces circuits restent dans leur état précédent.

Le cycle est terminé quand apparaît le temps T0 suivant.

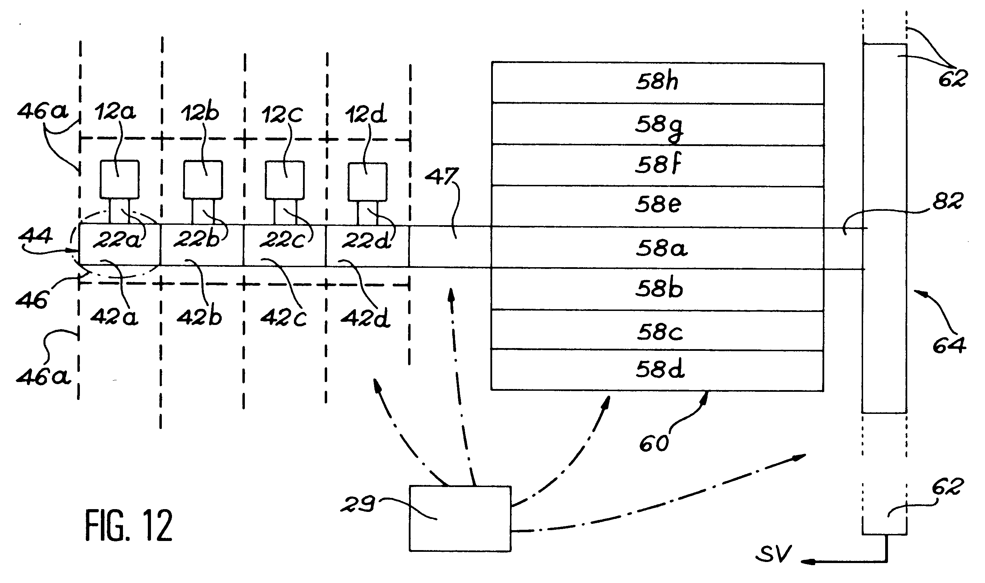

La figure 12 représente schématiquement une vue partielle d'une troisième variante de réalisation d'un dispositif conforme à l'invention.

Les étages du processeur 60 présentent une forme de bande allongée selon l'alignement d'une ligne. Les étages formant les deux successions sont disposés parallèlement entre eux et perpendiculairement à l'alignement de la ligne, de part et d'autre de l'étage central 58a.

Pour des commodités de représentation, ces étages débordent du pas de la zone de détection 46a, mais comme on l'a vu précédemment, le processeur 60 est contenu dans le pas des lignes de détecteurs pour éviter les zones aveugles.

La première succession comporte trois étages 58b, 58c, 58d (N-1 étages pour une ligne de N détecteurs) ; la seconde succession comporte quatre étages 58e, 58f, 58g, 58h (N étages pour une ligne de N détecteurs).

Les transferts des signaux s'effectuent de la même manière que dans le cas de la réalisation selon la première variante ; mais la délivrance du signal est effectuée par l'étage central 58a à la suite des trois décalages vers "l'arrière" dans le processeur 60 pour un défilement dans le sens aller de l'image, et à la suite des quatre décalages synchrones avec les transferts provenant du multiplexeur 44 pour un défilement dans le sens retour.

Un interrupteur 82 réalisé par une structure de type DTC à un étage permet le transfert du signal de sortie à un étage 62 du multiplexeur 64.

Les grilles de chacun des étages du processeur 60 présentent dans cette réalisation une surface égale à N fois la surface d'une grille d'un étage du multiplexeur (pour une ligne de N détecteurs) dans le cas d'un circuit de commande 47 à un étage. Ces grilles présentent une surface égale à N(Cs/(Cs+Cp)) fois la surface d'une grille d'un étage du multiplexeur pour un circuit de commande à trois étages.

Le rejet des processeurs TDI en dehors des zones de détection permettent de réduire l'encombrement des circuits de détection et par conséquent de disposer un grand nombre de détecteurs dans une ligne. Les signaux, somme des signaux représentatifs d'un élément de l'image ayant défilé sur l'ensemble des détecteurs d'une ligne, présentent par conséquent un rapport signal/bruit amélioré.

Par ailleurs, les prises de vues effectuées lors du défilement de l'image dans chacun des sens aller et retour permet d'avoir des prises de vue sans temps mort. En outre, l'utilisation de processeurs respectant le pas des lignes de détecteurs permet de ne pas être limitée en nombre de détecteurs par colonnes et permet en particulier l'association de plusieurs matrices de détecteurs.

## Revendications

1. Dispositif pour prises de vues à circuits de balayage intégrés comprenant :
plusieurs détecteurs (12) arrangés en lignes et en colonnes, ces détecteurs (12) délivrant un signal électrique proportionnel à leur éclairement, N étant le nombre de détecteurs (12) formant une ligne,
un système optique (27) apte à faire défiler une image (30) en translation sur les colonnes de détecteurs, perpendiculairement à celles-ci,
plusieurs circuits de lecture (22) ayant une structure de type "dispositif à transfert de charge" (DTC) intégrés sous les détecteurs, connectés chacun à un détecteur (12), chaque circuit de lecture (22) étant apte à effectuer une lecture du signal électrique délivré par le détecteur (12) auquel il est connecté, en relation avec le défilement de l'image et délivrant un signal de lecture,
pour chaque ligne, un circuit de balayage des colonnes ayant une structure de type DTC apte à additionner les signaux de lecture correspondant à la détection d'un même élément de l'image défilant successivement sur les détecteurs (12) d'une même ligne, et délivrant des signaux représentatifs des éléments de l'image (30) ayant défilé sur tous les détecteurs (12) d'une ligne,
un circuit de balayage des lignes constitué d'un multiplexeur de lignes (64) ayant une structure de type DTC et possédant autant d'étages (62) qu'il y a de lignes de détecteurs (12), chaque étage (62) étant relié à un circuit de balayage des colonnes, ce multiplexeur (64) délivrant un signal représentatif d'un colonne de l'image formé par les différents signaux délivrés par les circuits de balayage des colonnes,
caractérisé en ce que, le système optique étant apte à faire défiler l'image (30) selon un ou deux sens de défilement opposés successifs,
les circuits de balayage des colonnes sont aptes à additionner les signaux de lecture correspondant à la détection d'un même élément de l'image défilant successivement sur les détecteurs (12) d'une même ligne et délivrent des signaux représentatifs des éléments de l'image (30) ayant défilé sur tous les détecteurs (12) d'une même ligne dans l'un et/ou l'autre sens, une partie de chaque circuit de balayage étant intégrée sous les détecteurs de la ligne correspondante et l'autre partie étant intégrée à côté de ladite ligne selon un pas inférieur ou égal au pas des lignes de détecteurs,
chaque circuit de balayage des colonnes comportant :
un multiplexeur colonnes (44) comportant N étages (42) intégré sous les détecteurs de la ligne correspondante, chaque étage (42) étant relié à un circuit de lecture (22), ce multiplexeur (44) étant apte à recopier dans ses différents étages (42) les signaux de lecture formés après une prise de vue, et à délivrer sur une sortie (SM) en multiplexage ces signaux de lecture,
au moins un processeur (60) intégré à côté des détecteurs de la ligne correspondante pour traiter les signaux délivrés par le multiplexeur colonnes (44) et réalisant une fonction de retard et de sommation, ce processeur (60) délivrant sur au moins une sortie des signaux représentatifs des éléments formant une ligne de l'image, chacun de ces signaux étant constitué par la somme des signaux correspondant au même élément de l'image ayant défilé sur tous les détecteurs (12) d'une ligne,
pour chaque processeur (60), un circuit de commande (47) connecté à une sortie du multiplexeur colonnes (44) et à une entrée du processeur (60), ce circuit (47) étant apte à autoriser ou interdire un transfert de signaux entre lesdits multiplexeur (44) et processeur (60).

2. Dispositif selon la revendication 1, caractérisé en ce que chaque processeur (60) comporte au moins 2N étages répartis en un étage central (58a) dans lequel sont effectuées les sommations relié à une première succession comportant au moins N-1 étages (58b, 58c, 58d) et à une seconde succession comportant au moins N étages (58e, 58f, 58g, 58h), le circuit de commande (47) étant relié audit étage central (58a).

3. Dispositif selon la revendication 2, caractérisé en ce que les étages de chaque processeur (60) présentent une forme de bande allongée selon l'alignement d'une ligne de détecteurs (12), les successions d'étages étant disposées de part et d'autre de l'étage central (58a) perpendiculairement à l'alignement de la ligne de détecteurs (12) mais dans le pas des lignes de détecteurs.

4. Dispositif selon la revendication 3, caractérisé en ce que pour chaque processeur (60) un interrupteur (82) ayant une structure de type DTC relie l'étage central (58a) à un étage (62) du multiplexeur de lignes (64).

5. Dispositif selon la revendication 2, caractérisé en ce que la seconde succession comporte N+1 étages (58e, 58f, 58g, 58h, 58i) et en ce que les signaux représentatifs des éléments successifs formant une ligne de l'image sont délivrés en sortie de l'un ou l'autre des étages extrêmes (58d, 58i) des successions en relation avec le sens de défilement de l'image (30), lesdits étages extrêmes étant reliés à un étage du multiplexeur de lignes.

6. Dispositif selon la revendication 5, caractérisé en ce que le circuit de commande (47) comporte un convertisseur de charges en tension (48) connecté à la sortie (SM) du multiplexeur colonnes (44) et relié par une connexion (54) à un convertisseur de tension en charges (50) connecté à l'étage central (58a) du processeur (60).

7. Dispositif selon la revendication 2, caractérisé en ce que chaque processeur (60) présente une forme en U, les deux successions d'étages formant les branches du U étant parallèles entre elles et à côté d'une ligne de détecteurs (12), l'étage central (58a) formant la base du U.

8. Dispositif selon la revendication 7, caractérisé en ce que les successions comportent chacune N+1 étages.

9. Dispositif selon la revendication 8, caractérisé en ce que pour chaque processeur (60), les étages extrêmes (58k, 58i) des successions sont reliés à des interrupteurs (78, 80) ayant une structure de type DTC, chacun des ces interrupteurs étant relié au même étage (62) du multiplexeur de ligne (64).

10. Dispositif selon la revendication 1, caractérisé en ce que le circuit de commande (47) présente une structure de type DTC à un étage et constitue un interrupteur.

11. Dispositif selon la revendication 10, caractérisé en ce que chaque étage du processeur (60) est au moins N fois plus étendu qu'un étage du multiplexeur colonnes (44).

12. Dispositif selon la revendication 1, caractérisé en ce que le circuit de commande (47) présente une structure de type DTC à trois étages dont un étage (70) réalise un condensateur de capacité Cs et est relié à la sortie du multiplexeur colonnes (44), un autre étage (74) réalise un condensateur de capacité Cp et est relié à l'étage cental (58a) du processeur (60) et un autre étage (72) constituant un interrupteur, ce circuit de commande constituant un interrupteur réalisant les fonctions d'ébasage et de partition des charges issues du multiplexeur colonnes.

13. Dispositif selon la revendication 12, caractérisé en ce que chaque étage du processeur (60) est au moins N(Cs/(Cs+Cp)) fois plus étendu qu'un étage du multiplexeur (44).

## Patentansprüche

1. Bildaufnahmeeinrichtung mit integrierter Ablenkschaltung, umfassend:
mehrere Detektoren (12), zu Zeilen und Spalten angeordnet, wobei diese Detektoren (12) ein ihrer Beleuchtungstärke proportionales elektrisches Signal liefern und N die eine Zeile bildende Anzahl Detektoren (12) ist,
ein optisches System (27), geeignet ein Bild (30) geradlinig an den Detektorenspalten vorbeilaufen zu lassen, senkrecht zu diesen,
mehrere Leseschaltungen (22) mit einer Struktur des Typs "Ladungstransfervorrichtung" (DTC), integriert unter den Detektoren, jede mit einem Detektor (12) verbunden, wobei jede Leseschaltung (22) imstande ist, das Signal, geliefert durch den Detektor (12) mit dem sie verbunden ist, in Verbindung mit dem Vorbeilaufen des Bildes zu lesen und ein Lesesignal zu liefern,
für jede Zeile eine Spaltenablenkschaltung mit einer DTC-Struktur, die fähig ist, die Lesesignale zu addieren, die der Detektion von ein und demselben Bildelements entsprechen, das nacheinander über die Detektoren (12) von ein und derselben Zeile läuft, und repräsentative Signale der Elemente des Bilds (30) zu liefern, die über alle Detektoren (12) von ein und derselben Zeile gelaufen sind,
eine Zeilenablenkschaltung, gebildet durch einen Zeilenmultiplexer (64) mit einer DTC-Struktur, der ebensoviele Stufen (62) aufweist wie es Zeilen von Detektoren (12) gibt, wobei jede Stufe (62) verbunden ist mit einer Spaltenablenkschaltung, wobei dieser Multiplexer (64) ein Signal liefert, das repräsentativ ist für eine Spalte des Bilds, gebildet durch die verschiedenen, durch die Spaltenablenkschaltungen gelieferten Signale,
**dadurch gekennzeichnet**,
daß das optische System imstande ist, das Bild (30) in einer oder zwei sukzessive entgegengesetzten Durchlaufrichtungen vorbeilaufen zu lassen,
dabei sind die Spaltenablenkschaltungen fähig, die Lesesignale zu addieren, die der Detektion desselben Bildelements entsprechen, das sukzessive über den Detektoren (12) derselben Zeile durchläuft, und liefern Signale, die repräsentativ sind für die Elemente des Bilds (30), die über allen Detektoren (12) derselben Zeile durchgelaufen sind in der einen und/oder der anderen Richtung, wobei ein Teil jeder Ablenkschaltung unter den Detektoren der entsprechenden Zeile integriert ist und der andere Teil neben der genannten Zeile integriert ist, entsprechend einer Teilung, die kleiner oder gleich der Teilung der Detektorenzeilen ist,
dabei umfassen die Ablenkschaltungen der Zeilen:
einen Spaltenmultiplexer, der N Stufen (42) umfaßt, die integriert sind unter den Detektoren der entsprechenden Zeile, wobei jede Stufe (42) verbunden ist mit einer Leseschaltung (22), wobei dieser Multiplexer (44) fähig ist, die nach einer Bildaufnahme gebildeten Lesesignale in seine -bzw. in seinenverschiedenen Stufen (42) zu kopieren und diese Signale im Multiplexing an einem Ausgang (SM) zu liefern,
wenigstens einen Prozessor (60), integriert neben den Detektoren der entsprechenden Zeile, um die durch den Spaltenmultiplexer (44) gelieferten Signale zu verarbeiten und, indem er eine Verzögerungs- und Summierfunktion ausübt, liefert dieser Prozessor (60) auf wenigstens einem Ausgang Signale, die repräsentativ sind für die Elemente, die eine Zeile des Bilds bilden, wobei jedes dieser Signale gebildet wird durch die Summe der Signale, die demselben Element des Bilds entsprechen, das über alle Detektoren (12) einer Zeile gelaufen ist,
für jeden Prozessor (60) eine Steuerschaltung (47), verbunden mit einem Ausgang des Spaltenmultiplexers (44) und mit einem Eingang des Prozessors (60), wobei diese Schaltung (47) imstande ist, einen Transfer von Signalen zwischen dem Multiplexer (44) und dem Prozessor (60) zuzulassen oder nicht zuzulassen.

2. Einrichtung nach Anspruch 1, dadurch gekennzeichnet, daß jeder Prozessor (60) wenigstens 2N Stufen umfaßt, gegliedert in eine Zentralstufe (58a), in der die Summierungen durchgeführt werden, verbunden mit einer ersten Folge, umfassend wenigstens N-1 Stufen (58b, 58c, 58d) und mit einer zweiten Folge, umfassend wenigstens N Stufen (58e, 58f, 58g, 58h), wobei die Steuerschaltung (47) verbunden ist mit der Zentralstufe (58a).

3. Einrichtung nach Anspruch 2, dadurch gekennzeichnet, daß die Stufen jedes Prozessors (60) die Form eines länglichen Bandes aufweisen entsprechend der Ausrichtung einer Zeile der Detektoren (12), wobei die Stufenfolgen beiderseits der Zentralstufe (58a) angeordnet sind, senkrecht zur Ausrichtung der Detektorenzeile (12), aber in der Teilung der Detektorenzeilen.

4. Einrichtung nach Anspruch 3, dadurch gekennzeichnet, daß für jeden Prozessor (60) ein Schalter (82) mit einer Struktur des Typs DTC die Zentralstufe (58a) verbindet mit einer Stufe (62) des Zeilenmultiplexers (64).

5. Einrichtung nach Anspruch 2, dadurch gekennzeichnet, daß die zweite Folge N+1 Stufen umfaßt (58e, 58f, 58g, 58h, 58i) und daß die für aufeinanderfolgende Elemente repräsentativen Signale, die eine Zeile des Bildes bilden, geliefert werden am Ausgang der einen oder der anderen der äußersten Stufen (58d, 58i) der Folgen in Verbindung mit der Durchlaufrichtung des Bilds (30), wobei die besagten äußersten Stufen verbunden sind mit einer Stufe des Zeilenmultiplexers.

6. Einrichtung nach Anspruch 5, dadurch gekennzeichnet, daß die Steuerschaltung (47) einen Wandler bzw. Umsetzer von Ladungen in Spannung (48) umfaßt, verbunden mit dem Ausgang (SM) des Spaltenmultiplexers (44) und verbunden über eine Verbindung (54) mit einem Umsetzer von Spannung in Ladungen (50), verbunden mit der Zentralstufe (58a) des Prozessors (60).

7. Einrichtung nach Anspruch 2, dadurch gekennzeichnet, daß jeder Prozessor eine U-Form aufweist, wobei die beiden Stufenfolgen, die die Schenkel des U bilden, zueinander parallel und neben einer Detektorenzeile (12) sind, wobei die Zentralstufe (58a) die Basis des U bildet.

8. Einrichtung nach Anspruch 7, dadurch gekennzeichnet, daß jede der Folgen N+1 Stufen umfaßt.

9. Einrichtung nach Anspruch 8, dadurch gekennzeichnet, daß für jeden Prozessor (60) die äußersten Stufen (58k, 58i) der Folgen verbunden sind mit Schaltern (78, 80) mit einer DTC-Struktur, wobei jeder dieser Schalter verbunden ist mit derselben Stufe (62) des Zeilenmultiplexers (64).

10. Einrichtung nach Anspruch 1, dadurch gekennzeichnet, daß die Steuerschaltung (47) eine Struktur des Typs DTC mit einer Stufe aufweist und einen Schalter bildet.

11. Einrichtung nach Anspruch 10, dadurch gekennzeichnet, daß jede Stufe des Prozessors (60) wenigstens N mal größer ist als eine Stufe des Spaltenmultiplexers (44).

12. Einrichtung nach Anspruch 1, dadurch gekennzeichnet, daß die Steuerschaltung (47) eine Struktur des Typs DTC mit drei Stufen aufweist, wovon eine Stufe (70) einen Kondensator der Kapazität Cs realisiert und verbunden ist mit dem Ausgang des Spaltenmultiplexers (44), eine andere Stufe einen Kondensator der Kapazität Cp realisiert und verbunden ist mit der Zentralstufe (58a) des Prozessors (60), und eine weitere Stufe (72) einen Schalter realisiert, wobei diese Steuerschaltung einen Schalter bildet, der die Funktionen der Ebasage (ébasage) und der Einteilung (partition) der von dem Spaltenmultiplexer stammenden Ladungen realisiert.

13. Einrichtung nach Anspruch 12, dadurch gekennzeichnet, daß jede Stufe des Prozessors (60) wenigstens N(Cs/(Cs+Cp) mal größer ist als eine Stufe des Multiplexers (44).

## Claims

1. Camera having integrated scanning circuits comprising several detectors (12) arranged in the form of rows and columns, said detectors (12) supplying an electrical signal proportional to their illumination, N being the number of detectors (12) forming a row; an optical system (27) able to move an image (30) in translation past the columns of detectors and perpendicular thereto, the optical system being able to move the image (30) in one or two successive, opposite movement directions; several reading circuits (22) having a charge couple device or CCD-type structure integrated beneath the detectors and each connected to one detector (12), each reading circuit (22) being able to read the electrical signal supplied by the detector (12) to which it is connected, in relation with the movement of the image and supplying a reading signal; a row scanning circuit constituted by a row multiplexer (64) having a CCD-type structure and having the same number of stages (62) as there are rows of detectors (12), each stage (62) being connected to a column scanning circuit, sand multiplexer (64) supplying a signal representing a column of the image formed by the different signals supplied by the column scanning circuits; for each row, a column scanning circuit having a CCD-type structure and able to add the reading signals corresponding to the detection of the same element of the image moving successively past the detectors (12) of the same row and supplying signals representative of the elements of the image (30) having passed over all the detectors (12) of a row; the column scanning circuits being able to add the reading signals corresponding to the detection of the same element of the image moving successively past the detectors (12) of a same row and supplying signals representing the elements of the image (30) having passed all the detectors (12) of a same row in one and/or the other direction, a part of each scanning circuit being integrated beneath the detectors of the corresponding row and the other part being integrated next to the said row with a spacing equal to or smaller than the spacing of the detector rows; each column scanning circuit comprising: a column multiplexer (44) having N stages (42) integrated beneath the detectors of the corresponding row, each stage (42) being connected to a reading circuit (22), said multiplexer (44) being able to record in its different stages (42) the reading signals formed after a photograph and to supply on a multiplexing output (SM) the said reading signals; at least one processor 960) integrated next to the detectors of the corresponding row in order to process the signals supplied by the column multiplexer (44) and performing a delay and summation function, said processor (60) supplying on at least one output signals representing elements forming a row of the image, each of these signals being constituted by the sum of the signals corresponding to the same element of the image having moved past all the detectors (12) of a row; for each processor (60), a control circuit (47) connected to an output of the column multiplexer (44) and to an input of the processor (60), said circuit (47) being able to allow or prevent a transfer of signals between the said multiplexer (44) and the processor (60).

2. Camera according to claim 1, characterized in that each processor (60) has at least 2N stages subdivided into a central stage (58a) in which are carried out the summations linked with a first succession having at least N-1 stages (58b, 58c, 58d) and a second succession having at least N stages (58e, 58f, 58g, 58h), the control circuit (47) being connected to the said central stage (58a).

3. Camera according to claim 2, characterized in that the stages of each processor (60) have an elongated strip shape in accordance with the alignment of a row of detectors (12), the successions of stages being located on either side of the central stage (58a) perpendicular to the alignment of the row of detectors (12), but in the spacing of the rows of detectors.

4. Camera according to claim 3, characterized in that for each processor (60) a switch (82) having a CCD-type structure connects the central stage (58a) to a stage (62) of the row multiplexer (64).

5. Camera according to claim 2, characterized in that the second succession has N+1 stages (58e, 58f, 58g, 58h, 58i) and the signals representing the successive elements forming a row of the image are supplied at the output of one or other of the end stages (58d, 58i) of the successions in relation to the movement direction of the image (30), said end stages being connected to one stage of the row multiplexer.

6. Camera according to claim 5, characterized in that the control circuit (47) has a charge-voltage converter (48) connected to the output (SM) of the column multiplexer (44) and connected by a connection (54) to a voltage-charge converter (50) connected to the central stage (58a) of the processor (60).

7. Camera according to claim 2, characterized in that each processor (60) has a U-shape, the two successions of stages forming the branches of the U being parallel to one another and next to a row of detectors (12), the central stage (58a) forming the base of the U.

8. Camera according to claim 7, characterized in that the successions have in each case N+1 stages.

9. Camera according to claim 8, characterized in that for each processor (60), the end stages (58k, 58i) of the successions are connected to switches (78, 80) having a CCD-type structure, each of these switches being connected to the same stage (62) of the row multiplexer (64).

10. Camera according to claim 1, characterized in that the control circuit (47) has a CCD-type structure with one stage and constitutes a switch.

11. Camera according to claim 10, characterized in that each stage of the processor (60) is at least N times more extensive than a stage of the column multiplexer (44).

12. Camera according to claim 1, characterized in that the control circuit (47) has a three-stage CCD-type structure, whereof one stage (70) constitutes a capacitor of capacitance Cs and is connected to the output of the column multiplexer (44), another stage (74) constitutes a capacitor of capacitance Cp and is connected to the central stage (58a) of the processor (60) and another stage (72) constitutes a switch, said control circuit constituting a switch performing the skinning and partitioning functions of the charges from the column multiplexer.

13. Camera according to claim 12, characterized in that each stage of the processor (60) is at least N(Cs/(Cs+Cp)) times more extensive than a stage of the multiplexer (44).
